Europäisches Patentamt

European Patent Office

Office européen des brevets

(11) Publication number: **0 055 564**
**B1**

# EUROPEAN PATENT SPECIFICATION

(45) Date of publication of patent specification: **25.02.87**

(21) Application number: **81305964.9**

(22) Date of filing: **18.12.81**

(51) Int. Cl.⁴: **G 11 C 17/00, H 01 L 27/10, H 01 L 29/08, H 01 L 21/26**

(54) Read only semiconductor memory device and method of making it.

(30) Priority: **26.12.80 JP 186886/80**

(43) Date of publication of application:
**07.07.82 Bulletin 82/27**

(45) Publication of the grant of the patent:
**25.02.87 Bulletin 87/09**

(84) Designated Contracting States:
**DE FR GB NL**

(56) References cited:
**FR-A-2 175 960**
**US-A-3 925 767**
**US-A-4 074 238**

**IBM TECHNICAL DISCLOSURE BULLETIN, vol.
15, no. 9, February 1973, pages 2919-2920, R.W.
KNEPPER: "Fet array personalization by ion
implantation"**

**IBM TECHNICAL DISCLOSURE BULLETIN, vol.
22, no. 11, April 1980, pages 5146-5147 E.
BASSOUS et al.: "Self-aligned polysilicon gate
mosfets with tailored source and drain
profiles"**

(73) Proprietor: **FUJITSU LIMITED**
**1015, Kamikodanaka Nakahara-ku
Kawasaki-shi Kanagawa 211 (JP)**

(72) Inventor: **Shirato, Takehide
6-26 Sengen-cho
Hiratsuka-shi Kanagawa 254 (JP)**

(74) Representative: **Rackham, Stephen Neil et al
GILL JENNINGS & EVERY 53-64 Chancery Lane
London WC2A 1HN (GB)**

Courier Press, Leamington Spa, England.

# Description

The present invention relates to a read-only semiconductor memory device (ROM) and especially to a ROM construction using a standard memory cell matrix which is programmed by the application of a single custom-made mask during the manufacturing process (hereinafter referred to as a "mask ROM"), and the method of manufacturing it.

Mask ROMs have information written into them during their manufacture. They are suited for cases where large volumes of ROMs with an identical memory content are used. Mask ROMs are consequently used for example in control memories in the microprogram-control-type computers, for program memories in microcomputers, and for various kinds of terminals.

Conventional mask ROMs may be classified into two different types. The first type is that where the information contained in the ROM is produced by the presence or absence, of electrode contact holes, the pattern of the contact holes being formed by a custom-made photomask. The transistors forming the standard memory cell matrix are matched with electrode contact holes selectively formed in their drain regions. Application of an input signal to the gate of the transistors results in either a high or low potential level output of each transistor depending on whether or not its each drain region is connected to the electric source via an electrode contact hole. The different outputs thus determine whether the information stored in each transistor is "0" or "1".

The first type of mask ROM is manufactured by the following process. Many enhancement type metal-insulator semiconductors (MIS) transistors, typically, metal-oxide semiconductor (MOS) transistors, are arranged on a semiconductor substrate to form the memory cell matrix. The substrate is then covered by an insulating layer. A program photomask is used selectively to form electrode contact holes in the insulation layer at the drain regions of the memory cells which are required to have a high output based on the information content required. Subsequent completion of the mask ROM requires only the formation of a surface protective layer on which the wiring is formed and the formation of the bonding pad.

This manufacturing process has an advantage in that the processing from the master slice to the completed mask ROM is very short. At the same time, however, the process has a disadvantage in that it is necessary to provide drain regions for the formation of electrode contact windows for each memory cell MOS transistor whether it is subsequently needed or not which reduces the integration density.

In the second type of mask ROM, the information is distinguished by having a different type of transistor forming each type of cell, typically the transistor is an enhancement type or depletion type of transistor. In the matrix, a plurality of memory cell MOS transistors are connected in series. A high level input signal is supplied to the gate of the non-selected MOS transistors and a low level input signal to the gate of the selected MOS transistors. This places selected MOS transistors of the enhancement type in the off state, and produces a high output level at the source terminal of the series-connected MOS transistors. At the same time, this places selected MOS transistors of the depletion type in the on state and produces a low output level at the source terminal of the series-connected MOS transistors. In other words, the matrix memory is formed as a NAND gate circuit.

In the manufacture of the second type of mask ROM when the MOS transistors are formed on the semiconductor substrate they are formed as enhancement type or depletion type. A programmed mask is used to create impurity introduction layers only in selected regions so that MOS transistors of either depletion type or enhancement type transistors are formed in accordance with the memory information to be programmed into the memory.

With the second type of mask ROM, it is not necessary to provide electrode contact windows for each of the MOS transistors and therefore the second type has a higher integration density than the first type. However, this second type of mask ROM carries out the programming step as part of the transistor formation step and thus requires many processing steps after the programming step before the mask ROM is completed, such as the formation of the gate electrodes and output wiring, the formation of the source and drain regions, the formation of the electrode contact windows for the matrix, the formation of the metallic wiring layer, the formation of the surface protective layer, and the formation of the bonding pad.

US—A—3925767 describes an erasable and reprogrammable read-only memory using a matrix of normally conducting MOS transistors that are selectively rendered non-conductive by selectively irradicating them with x-ray or x-ray radiation after their formation. To erase the programmed information the memory is subjected to a heat treatment to anneal out the damage caused during the irradiation step.

A ROM is known from FR—A—2175960 in which, before the FETs are formed, regions are deposited at sites where a binary one is to be stored. These regions short circuit the source and drain of the FETs later formed on those sites. The programmed array thus consists of conventionally functioning FETs and short circuited ones.

A ROM is known from IBM Technical Disclosure Bulletin, Vol. 15, No. 9, February 1973, page 2919, in which a FET array is programmed by ion implantations to extend the source and drain of selected FETs and thus complete their channels. The programmed array thus consists of incomplete FETs which cannot conduct and ones which function conventionally.

The aim of the present invention is to provide a ROM semiconductor device (mask ROM) offering a similar integration density and similar type of memory cell as the second type but in which the memory cell matrix is completed before programming takes place.

According to one aspect of this invention a read-only memory semiconductor device in which a plurality of MIS-type transistors are arranged in a matrix with each one of the transistors corresponding to one bit of information and in which binary information is stored in accordance with whether each of the transistors conducts or does not conduct when a voltage is applied between its source and drain and no voltage is applied to its gate, characterised in that at least one of the source and drain region of an MIS transistor that conducts when a voltage is applied between its source and drain and no voltage is applied to its gate extends to a greater extent than the corresponding region of the MIS transistors that do not conduct when a voltage is applied between its source and drain and no voltage is applied to its gate.

According to another aspect of this invention a method of manufacturing semiconductor read only memory devices in accordance with the one aspect of this invention is characterised in that after formation of the memory cell matrix programming is carried out by performing a selective ion implantation step on the at least one of the source and drain regions of the MIS transistors that conduct when a voltage is applied between their source and drain and no voltage is applied to their gate, the ions being selectively implanted having a greater coefficient of diffusion than those used to form the source and drain regions of the MIS transistors that do not conduct when a voltage is applied between their source and drain and no voltage is applied to their gate, so that, upon a subsequent heat treatment step the at least one of the source and drain regions of the MIS transistor that conduct when a voltage is applied between their source and drain and no voltage is applied to their gate are formed with a greater extent than the source and drain regions of the MIS transistors that do not conduct when a voltage is applied between their source and drain regions and no voltage is applied to their gate.

Preferably the ions selectively implanted have a greater coefficient of diffusion than those used to form the source and drain regions of the MIS transistors that do not conduct when a voltage is applied between their source and drain and no voltage is applied to their gate, so that, upon a subsequent heat treatment step the at least one of the source and drain regions of the MIS transistor that conduct when a voltage is applied between their source and drain and no voltage is applied to their gate are formed with a greater extent than the source and drain regions of the MIS transistors that do not conduct when a voltage is applied between their source and drain regions and no voltage is applied to their gate.

Particular examples of semiconductor read only memory devices and their method of manufacture will now be described and contrasted with the prior art with reference to the accompanying drawings, in which:—

FIGS. 1 and 2 are circuit diagrams of conventional semiconductor read only memory devices;

FIG. 3 is a circuit diagram of one example of a semiconductor memory device in accordance with the present invention;

FIGS. 4A and 4B are a plan of and a section through, respectively, the one example of the semiconductor memory device shown in FIG. 3;

FIGS. 5A and 5E are sections through the one example at various stages during its manufacture;

FIG. 6 is a section through another example of a device in accordance with the present invention.

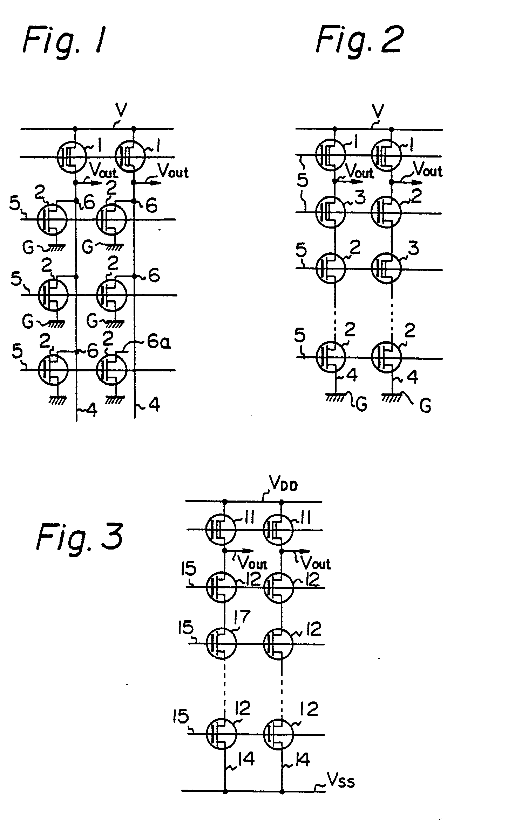

FIG. 1 illustrates a circuit of a conventional mask ROM in which the binary information to be written in is distinguished by the presence or absence of electrode contact holes. FIG. 1 illustrates an example of an n channel-type device. In FIG. 1, depletion-type MOS transistors 1 are connected between an electric source voltage V and bit lines 4 are load transistors. Enhancement-type MOS field-effect transistors 2 are used for memory cells, and are connected at the gate to word lines 5 and grounded at the source. In FIG. 1, it should be noted that the drains of the transistors 2 are connected to the bit lines 4 when the drains have electrode contacts, and are not connected when they do not. In FIG. 1, reference number 6a shows the case where the drain has no electrode contact. The circuit shown in FIG. 1 forms a NOR-type circuit. That is, in FIG. 1, when a high input level signal is applied to a selected word line 5 and a drain having an electrode contact is connected to the bit line 4, a current flows through the transistor connected to said word line to place the output $V_{out}$ of the bit line at a low level. However, when the drain has no electrode contact and is not connected to the bit line, no current flows in the bit line through said transistor, therefore leaving the output $V_{out}$ of the bit line at a high level. This allows the differentiation of binary information in the transistors 2. As mentioned previously, this method does not allow high integration density, because regions for forming electrode contact windows must be provided for each memory cell MOS transistors.

FIG. 2 illustrates a circuit of a conventional mask ROM in which the binary information to be written is distinguished by the formation of the MOS field-effect transistors as enhancement types or depletion types. FIG. 2 also illustrates an example of n channel type device. In FIG. 2, depletion-type MOS transistors 1 are connected to the electric source voltage V as load transistors as in FIG. 1. A plurality of MOS transistors are connected in series to the load transistors 1 and are formed as enhancement-type transistors 2 or depletion-type transistors 3 in accordance with whether the information to be stored is "0" or "1". The circuit shown in FIG. 2 forms a NAND-type circuit. In FIG. 2, the gates of each transistor 2 and 3 are connected to word lines 5, and the series-connected sources and drains of the transistors 2 and 3 form the bit lines 4. In the circuit shown in FIG. 2, during the readout operation, a high level input signal is supplied nonselectively to each word line to place the MOS transistors for nonselected memory cells in the on state regardless of whether said MOS transistors are of the enhancement type or depletion type. Application of a low level input signal to the word line to be selected places MOS transistors which are connected to this word line, and which are enhancement types, into a nonconductive state and cuts off the source and the drain of those MOS transistors, placing the output $V_{out}$ at the high level. When the MOS transistors are depletion types, the output $V_{out}$ remains at the low level. This allows the differentiation of the information stored in the transistors 2 and 3. In this type of mask ROM, the establishment in the programming process of enhancement characteristics or depletion characteristics for each memory cell MOS transistor must be followed by many processes, including a gate-forming process, before the mask ROM is completed, as mentioned previously.

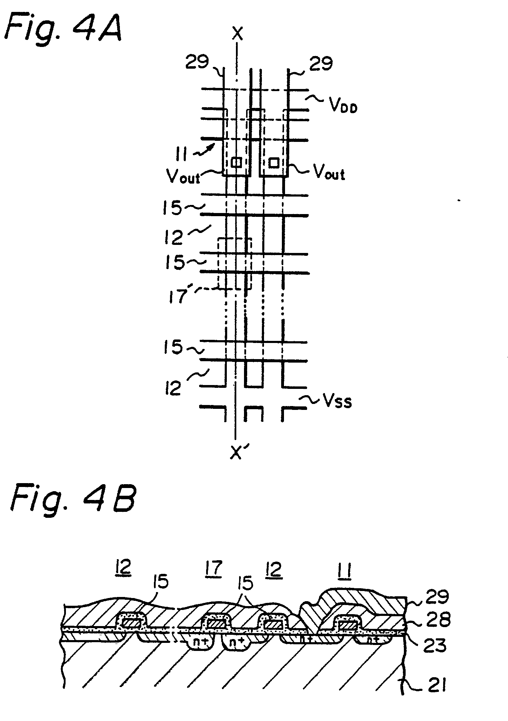

FIG. 3 illustrates a circuit of a semiconductor memory device based on the present invention and FIG. 4A a plan view of the device shown in FIG. 3.

As shown in FIG. 3 and FIG. 4A, the memory cell array in a semiconductor memory device based on the present invention is similar to the conventional memory cell array shown in FIG. 2. That is, depletion-type MIS transistors are connected to a drain electric source voltage $V_{DD}$ as load transistors. A plurality of MIS transistors 12 of a normally off characteristic (typically enhancement-type MOS transistors) and MIS transistors 17 of a normally on characteristic are connected in series, according to the program information, so as to form a plurality of bit lines 14, the ends of the bit lines 14 being connected to the source line $V_{SS}$ grounded as shown in FIG. 3. The gates of the MIS transistors are formed in the same positions in each bit line 14 and are connected to the word lines 15, which are arranged at right angles to the bit lines 14. This forms a memory matrix cell. The output wires $V_{out}$ are connected to the load transistors 11 of each bit line 14 and the memory cell transistor sequences. The memory cell MIS transistors where information, for example "1", in each bit line 14 is written is formed with a normally-on-type transistor, especially, a punch-through-type MIS transistor. Here, "punch-through-type MIS transistor" means an MIS transistor where the current flows between the source and the drain when the voltage is applied between them if no voltage is applied to the gate, because of the short distance between the source and the drain in the already known MIS technique.

To read out the information written in the semiconductor memory device, high voltage is applied to nonselected word lines in the memory device and low voltage to the selected word lines. When the memory cell of the bit line connected to the selected word line is formed by a normally-on-type MIS transistor corresponding to "1" information, such as a punch-through-type transistor, all transistors connected to the bit line are placed in the on state, with the result that the output $V_{out}$ of the bit line is placed at the low voltage level. However, if the memory cell of the bit line connected to the selected word line is formed by a normally-off-type MIS transistor, such as an enhancement-type transistor, the enhancement transistor connected to the bit line is placed in the off state, with the result that the output $V_{out}$ of the bit line is placed at a high voltage level nearly equal to voltage $V_{DD}$. This allows the stored information to be read out by the output level of each bit line.

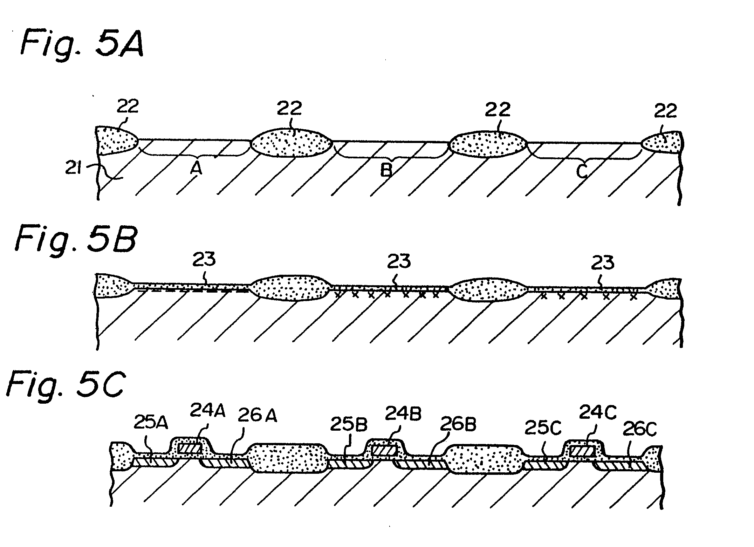

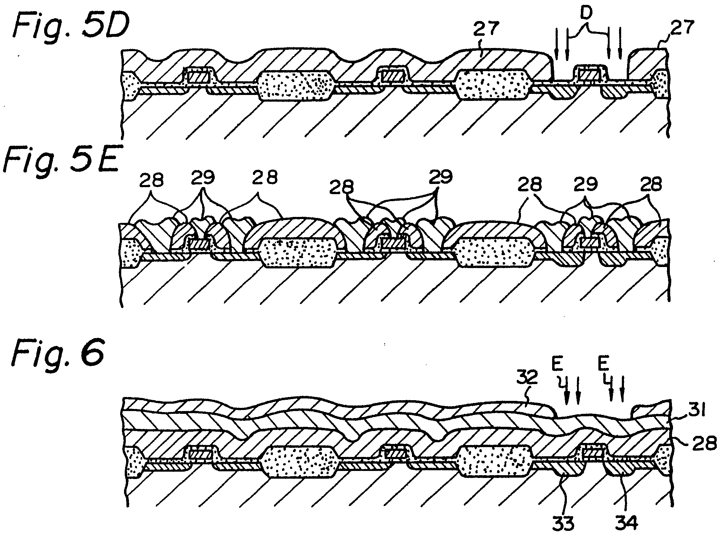

FIG. 5A through FIG. 5E illustrate cross-sections explaining the method of the first embodiment of the manufacture of the semiconductor memory device shown in FIG. 3. FIG. 6 illustrates a cross-section explaining the method of the second embodiment of the manufacture of the same.

With reference to FIG. 5A through FIG. 5E, one embodiment of the manufacture of an n channel-type semiconductor memory device, will now be shown. First, a field oxide silicate ($SiO_2$) layer 22 is formed on the P-type silicon substrate 21 so as to separate the transistor elements. In FIG. 5A, A illustrates the region where the depletion-type transistor element for the load transistor will be formed, B the region where the enhancement-type transistor element will be formed, and C the region where the punch-through-type transistor will be formed. The information to be written determines whether a punch-through-type or enhancement-type transistor is formed. Therefore, which region will have the punch-through-type transistor is unknown at this stage. For the purpose of discussion only, we assume that the punch-through-type transistor will be formed on region C. In FIG. 5A, the memory cell transistors are individually surrounded by field oxide film. In an actual series connection of the memory cell transistors, however, adjacent transistors are not separated by field oxide film but are connected by an n-type region commonly used for the source and the drain.

Next, as shown in FIG. 5B, after a gate oxidation film 23 is formed on the substrate, a photoresist film (not shown) for the pattern formation is formed on the substrate, and boron (B) ions are implanted in the region where the enhancement-type transistor will be formed so as to adjust the threshold voltage of said transistor. Boron (B) is also injected to the region where the punch-through-type transistor will be formed. The photoresist film is then removed. Another photoresist film (not shown) for pattern formation is formed on the substrate, and phosphorous (P) is ion implanted in the region where the depletion-type transistor will be formed so as to adjust the surface current (IDSS) of the depletion-type transistor formed thereon. These ioninjection processes are well known in the manufacture of conventional enhancement- and depletion-type MIS integration circuits. A polysilicon film is then formed on the substrate by a chemical vapor deposition method so as to form gate electrodes, and a photresist film is formed over the substrate. The photoresist film is formed in a predetermined pattern by the photoetching method. The polysilicon gate electrodes are formed in a predetermined pattern using the patterned photoresist film as a mask. In FIG. 5C, 24A, 24B, and 24C illustrate polysilicon gate electrodes formed by the above-mentioned process. Next, the surface of the polysilicon gate electrodes and the regions (the source and drain regions) where the transistor elements will be formed are oxidized. Then, arsenic (As) is ion injected in the regions where the depletion-type transistors, the enhancement-type transistors, or the punch-through type transistors will be formed so as to form the source regions 25A, 25B and 25C and the drain regions 26A, 26B, 26C, as shown in FIG. 5C.

The process from FIG. 5A through FIG. 5C is a common process not involving program information. The process is stopped at this point with the device in an incomplete state, as shown in FIG. 5C, to wait for the desired program. The subsequent program process is started when the specific write information is decided upon.

In the program process, the information to be written is used as the basis for the formation of a photoresist film 27, as shown in FIG. 5D, on all regions except regions where source drains of punch-through-type transistors will be formed. Phosphorous (P) having a larger diffusion coefficient than the impurity arsenic (As), which has already been introduced in the source·drain regions, is ioninjected as shown with the arrow D. In the end, this source·drain region is formed to a depth greater than elsewhere for the formation of punch-through-type transistors. Thereafter, the photoresist film 27 is removed; a phospho-silicate glass (PSG) film 28 is formed as shown in FIG. 5E for an insulation film; and windows are formed for the contact holes for leading out wires from the source regions, drain regions, and gate electrodes. This allows the formation of an aluminum (Al) wiring film 29. After formation, said film is subjected to the plasma-etching method to produce a wiring pattern of a predetermined pattern.

The above-mentioned removal of the photoresist film 27 should preferably be followed by heat treatment to anneal the injected ions. In this process, heat diffusion of phosphor (P), which is larger than the diffusion of arsenic (As), would help to ensure the proper formation of the punch-through-type transistors. An excessive degree of diffusion by the phosphorous would cause contact between the source·drain regions and thus would not result in a punch-through characteristic, but rather in a normally on characteristic, that is, characteristic where the source and drain are in the on state without application of gate voltage. This would not, however, obstruct the performance of the ROM device.

The above-mentioned process allows the output wires $V_{out}$ of each bit line, formed by series connection of transistors in the element-formation region on the semiconductor substrate, to be formed at the same time as the gate wiring, for example by forming a silicon dioxide film during the above-mentioned manufacturing process, then removing one portion of said silicon dioxide film from the source region of the load transistors. In the portion where the silicon dioxide film is removed, the output wires are connected to the substrate, via polysilicon layer. The resultant connection construction by the polysilicon layer is the so-called buried contact construction.

In a semiconductor device having the construction of the present invention, when the source·drain regions of the MIS transistors forming the semiconductor memory device are formed, the source regions and the drain regions of certain specified transistors are formed at a greater depth so to form punch-through-type transistors. Thereafter, well known methods can be followed for the formation of phospho-silicate glass (PSG) film, the formation of the electrode contact windows to the PSG film, the formation of the wiring layer using aluminum (Al), the formation of the surface protective layer, the formation of the bonding pad, etc. This invention therefore, allows the shortening of the process from writing in the information to the completion of the device.

Returning to FIG. 4A and FIG. 4B, FIG. 4B shows X—X' section construction of a mask ROM of the plan construction of FIG. 4A manufactured by the process mentioned above. The area 17' boxed in by the broken line in FIG. 4A corresponds to the window pattern in the photoresist film 27 in the program shown in FIG. 5D. Therefore, the MIS transistor 17 is exposed by the window and formed as a punch-through-type transistor. The other transistors 12 for the memory cells remain as enhancement-type transistors.

One example of the preferred conditions for carrying out the embodiment of the present invention is as follows. The width of the electrode pattern of the gate polysilicon in the memory cell transistor is 3 microns. The thickness of the gate oxide film is 400 Å. The injection amount of the arsenic (As) ion for forming the source·drain regions is $4 \times 10^{15}$ cm$^{-2}$ and its injection energy is 120 keV. When the thickness of the heat oxide film formed on the surfaces of the gate polysilicon layer and the source·drain regions is 500 Å after the source drain regions is formed, the injection amount of the phosphorous (P) for the programming is $1 \times 10^{16}$ cm$^{-2}$ and its injection energy is 70 keV. The heat treatment carried out after these ion injection processes is carried out at 1050°C for 20 minutes.

FIG. 6 illustrates another embodiment of the present invention. As shown in FIG. 6, first one forms a PSG film 31 having low phosphorous density and a metal film 32, for example, of aluminum (Al), in accordance with the predetermined pattern. This prepares the device for the following programming process. In the programming process, the portion of the aluminum film 32 corresponding to the source regions and the drain regions of the element regions for the punch-through-type transistors are removed according to the information to be written. Thereafter, a carbon dioxide-gas ($CO_2$) laser beam is directed on the substrate. The section of the laser beam striking the aluminum film 32 is reflected and dispersed, however, the section striking the areas where the aluminum film was removed penetrates to the source region 33 and the drain region 34, which were previously formed by injecting source and drain impurity atoms. This locally heats the source region and the drain region to diffuse the impurity atoms in the substrate. The diffusion layer in this area is consequently formed to a greater depth to produce a punch-through transistor. An excessive degree of diffusion of the local impurity, in this case, too, would result in contact between source and drain regions and an effect different from the punch-through effect, but the result would be a normally on characteristic and this would not obstruct the performance of the ROM device. One subsequently removes the now unnecessary aluminum film.

As explained in detail above, the semiconductor device and manufacturing method of the present invention makes possible a mask-ROM-type semiconductor memory device having a high density and short fabrication process after programming.

Further, the circuit type shown in FIG. 3 of the specification illustrates only one embodiment for carrying out the present invention. Other embodiments, for example, a circuit for dynamic operation using MIS transistors which receive bit selection signals instead of the load transistor 11, can be carried out.

**Claims**

1. A read-only memory semiconductor device in which a plurality of MIS-type transistors (12, 17) are arranged in a matrix with each one of the transistors corresponding to one bit of information and in which binary information is stored in accordance with whether each of the transistors (12, 17) conducts or does not conduct when a voltage is applied between its source and drain and no voltage is applied to its gate, characterised in that at least one of the source (25C) and drain (26C) region of an MIS transistor (17) that conducts when a voltage is applied between its source and drain and no voltage is applied to its gate extends to a greater extent than the corresponding region of the MIS transistors (12) that do not conduct when a voltage is applied between its source and drain and no voltage is applied to its gate.

2. A read-only memory semiconductor device according to claim 1, wherein the MIS-type transistors (12) that conduct when a voltage is applied between their source and drain and no voltage is applied to their gate are punch-through-type transistors.

3. A read-only memory semiconductor according-

ing to claim 1, wherein the source region (25C) and the drain region (26C) of the MIS-type transistors that conduct when a voltage is applied between their source and drain and no voltage is applied to their gate are connected with one another.

4. A method of manufacturing a read-only memory semiconductor device in accordance with claim 1, characterised in that after formation of the memory cell matrix programming is carried out by performing a selective ion implantation step on the at least one of the source (25C) and drain (26C) regions of the MIS-type transistors (12) that conduct when a voltage is applied between their source and drain and no voltage is applied to their gate, to increase the impurity density in this region to form them with a greater extent than the source (25A and B) and drain (26A and B) regions of the MIS transistors (12) that do not conduct when a voltage is applied between their source and drain region and no voltage is applied to their gate.

5. A method according to claim 4, characterised in that the ions selectively implanted have a greater coefficient of diffusion than those used to form the source (25A and B) and drain (26A and B) regions of the MIS transistors (12) that do not conduct when a voltage is applied between their source and drain and no voltage is applied to their gate, so that, upon a subsequent heat treatment step the at least one of the source (25C) and drain (26C) regions of the MIS transistor (12) that conduct when a voltage is applied between their source and drain and no voltage is applied to their gate are formed with a greater extent than the source (25A and B) and drain (26A and B) regions of the MIS transistors (12) that do not conduct when a voltage is applied between their source and drain regions and no voltage is applied to their gate.

6. A method of manufacturing a read-only memory semiconductor device in accordance with claim 1, characterised in that after formation of the memory cell matrix programming is carried out by directing a high energy beam at the at least one of the source (25C) and drain (26C) regions of the MIS transistors (12) that conduct when a voltage is applied between their source and drain and no voltage is applied to their gate locally to heat the source (25C) and/or drain (26C) regions of the transistors to cause greater diffusion of the impurities in these regions and hence form these regions with a greater extent.

**Patentansprüche**

1. Nur-Lese-Halbleiterspeichervorrichtung, bei welcher eine Anzahl von MIS-Transistoren (12, 17) in einer Matrix angeordnet sind, wobei jeder der Transistoren, der einem Bit von Information entspricht und in dem benäre Information in Übereinstimmung damit gespeichert ist, ob jeder der Transistoren (12, 17) leitet oder nicht leitet, wenn eine Spannung zwischen seiner Source und seiner Drain zugeführt und keine Spannung seinem Gate zugeführt wird, dadurch gekennzeichnet, daß wenigstens einer der Source- (25C) und Drainbereiche (26C) eines MIS-Transistors (17), welcher leitet, wenn eine Spannung zwischen seiner Source und Drain zugeführt und keine Spannung seinem Gate zugeführt wird, sich in einem größeren Ausmaß als der entsprechende Bereich des MIS-Transistors (12) erstreckt, der nicht leitet, wenn eine Spannung zwischen seiner Source und Drain zugeführt und keine Spannung seinem Gate zugeführt wird.

2. Nur-Lese-Halbleiterspeichervorrichtung nach Anspruch 1, bei welcher die MIS-Transistoren (12), die leiten, wenn eine Spannung zwischen ihrer Source und Drain zugeführt wird und keine Spannung ihrem Gate zugeführt wird, Transistoren vom Durchgriffstyp sind.

3. Nur-Lese-Halbleiterspeichervorrichtung nach Anspruch 1, bei welcher der Sourcebereich (25C) und der Drainbereich (26C) der MIS-Transistoren, die leiten, wenn eine Spannung zwischen ihrer Source und Drain zugeführt wird und keine Spannung ihrem Gate zugeführt wird, miteinander verbunden sind.

4. Verfahren zur Herstellung einer Nur-Lese-Halbleiterspeichervorrichtung nach Anspruch 1, dadurch gekennzeichnet, daß nach Bildung der Speicherzellenmatrix die Programmierung durch Durchführen eines selektiven Ionenimplantationsschrittes auf wenigstenseinem der Source- (25C) und Drainbereiche (26C) der MIS-Transistoren (12) durchgeführt wird, die leiten, wenn eine Spannung zwischen ihrer Source und Drain zugeführt wird und keine Spannung ihrem Gate zugeführt wird, um die Verunreinigungsdichte in diesem Bereich zu erhöhen, um sie mit einer größeren Erstreckung als die Source- (25A und B) und Drain- (26A und B) -Bereiche der MIS-Transistoren (12) zu bilden, die nicht leiten, wenn eine Spannung zwischen ihrem Source- und Drainbereich zugeführt und keine Spannung ihrem Gate zugeführt wird.

5. Verfahren nach Anspruch 4, dadurch gekennzeichnet, daß die selektiv implantierten Ionen einen größeren Diffusionskoeffizienten als diejenigen haben, die zur Bildung der Source- (25A und B) und Drainbereiche (26A und B) der MIS-Transistoren (12) verwendet werden, die nicht leiten, wenn eine Spannung zwischen ihrer Source und Drain zugeführt und keine Spannung ihrem Gate zugeführt wird, so daß, bei dem folgenden Wärmebehandlungsschritt von wenigstens einem der Source- (25C) und Drainbereiche (26C) der MIS-Transistoren (12), die leiten, wenn eine Spannung zwischen ihrer Source und Drain und keine Spannung ihrem Gate zugeführt wird, mit einer größeren Erstreckung gebildet werden als die Source- (25A und B) und Drainbereiche (26A und B) der MIS-Transistoren (12), die nicht leiten, wenn eine Spannung zwischen ihren Source- und Drainbereichen zugeführt und keine Spannung ihrem Gate zugeführt wird.

6. Verfahren zur Herstellung einer Nur-Lese-Halbleiterspeichervorrichtung nach Anspruch 1, dadurch gekennzeichnet, daß nach Bildung der Speicherzellenmatrix die Programmierung durch Dirigieren eines Hochenergiestrahls auf wenigstens einen der Source- (25C) und Drainbereiche (26C) der MIS-Transistoren (12) durchgeführt wird, die leiten, wenn eine Spannung zwischen ihrer Source und ihrer Drain zugeführt wird und keine Spannung ihrem Gate zugeführt wird, um die Source- (25C) und/oder Drainbereiche (26C) der Transistoren lokal zu erwärmen, um eine größere Diffusion der Verunreinigungen in diesen Bereichen zu verursachen und damit diese Bereiche mit einer größeren Erstreckung zu bilden.

**Revendications**

1. Dispositif semiconducteur de mémoire morte dans lequel plusieurs transistors du type MIS (12, 17) sont disposés suivant une matrice de sorte que chacun des transistors corresponde à un bit d'information et dans lequel l'information binaire est emmagasinée d'après le fait que chacun des transistors (12, 17) conduit ou non lorsqu'une tension est appliquée entre sa source et son drain et qu'aucune tension n'est appliquée à sa grille, caractérisé en ce qu'au moins une région, parmi la région de source (25C) et la région de drain (26C), d'un transistor MIS (17) qui conduit lorsqu'une tension est appliquée entre sa source et son drain et qu'aucune tension n'est appliquée à sa grille, s'étend sur une plus grande étendue que la région correspondante des transistors MIS (12) qui ne conduisent pas lorsqu'une tension est appliquée entre leur source et leur drain et qu'aucune tension n'est appliquée à leur grille.

2. Dispositif semiconducteur de mémoire morte selon la revendication 1, où les transistors de type MIS (12) qui conduisent lorsqu'une tension est appliquée entre leur source et leur drain et qu'aucune tension n'est appliquée à leur grille sont des transistors du type à tension de perçage.

3. Dispositif semiconducteur de mémoire morte selon la revendication 1, où la région de source (25C) et la région de drain (26C) des transistors de type MIS qui conduisent lorsqu'une tension est appliquée entre leur source et leur drain et qu'aucune tension n'est appliquée à leur grille sont connectées l'une à l'autre.

4. Procédé de fabrication d'un dispositif semiconducteur de mémoire morte selon la revendication 1, caractérisé en ce que, après la formation de la matrice de cellules de mémoire, on effectue la programmation en exécutant une opération d'implantation ionique sélective sur la ou les régions, parmi les régions de source (25C) et de drain (26C), des transistors de type MIS (12) qui conduisent lorsqu'une tension est appliquée entre leur source et leur drain et qu'aucune tension n'est appliquée à leur grille, afin d'augmenter la densité d'impureté dans cette région pour lui donner une plus grande étendue que les régions de source (25A et B) et de drain (26A et B) des transistors MIS (12) qui ne conduisent pas lorsqu'une tension est appliquée entre leur région de source et leur région de drain et qu'aucune tension n'est appliquée à leur grille.

5. Procédé selon la revendication 4, caractérisé en ce que les ions sélectivement implantés ont un plus grand coefficient de diffusion que ceux utilisés pour former les régions de source (25A et B) et de drain (26A et B) des transistors MIS (12) qui ne conduisent pas lorsqu'une tension est appliquée entre leur source et leur drain et qu'aucune tension n'est appliquée à leur grille, si bien que, lors d'une opération ultérieure de traitement thermique, la ou les régions, parmi les régions de source (25C) et de drain (26C), des transistors MIS (12) qui conduisent lorsqu'une tension est appliquée entre leur source et leur drain et qu'aucune tension n'est appliquée à leur grille reçoivent une plus grande étendue que les régions de source (25A et B) et de drain (26A et B) des transistors MIS (12) qui ne conduisent pas lorsqu'une tension est appliquée entre leur région de source et de leur région de drain et qu'aucune tension n'est appliquée à leur grille.

6. Procédé de fabrication d'un dispositif semiconducteur de mémoire morte selon la revendication 1, caractérisé en ce que, après la formation de la matrice de cellules de mémoire, on effectue la programmation en dirigeant un faisceau d'énergie élevée sur la ou les régions, parmi les régions de source (25C) et de drain (26C), des transistors MIS (12) qui conduisent lorsqu'une tension est appliquée entre leur source et leur drain et qu'aucune tension n'est appliquée à leur grille afin d'échauffer localement les régions de source (25C) et, ou bien, de drain (26C) des transistors pour provoquer une plus grande diffusion des impuretés dans ces régions et, de ce fait, donner à ces régions une plus grande étendue.

# Fig. 1

# Fig. 2

# Fig. 3

*Fig. 4A*

*Fig. 4B*

Fig. 5A

Fig. 5B

Fig. 5C

*Fig. 5D*

27    D    27

*Fig. 5E*

28    29    28    28    29    28    29    28

*Fig. 6*

32    E    E    31

28

33    34